# EUROPEAN PATENT SPECIFICATION

(11) **EP 3 897 087 B1**
(45) Date of publication and mention of the grant of the patent: **10.09.2025**
(21) Application number: 18943198.4
(22) Date of filing: 11.12.2018
(51) Int. Cl.: H05K 13/00, H05K 13/02, H05K 13/04, H05K 13/08

(54) **MOUNTING SYSTEM AND METHOD OF ARRANGING COMPONENT FEEDING UNITS**
MONTAGESYSTEM UND VERFAHREN ZUM ANORDNEN VON KOMPONENTENZUFÜHRUNGSEINHEITEN
SYSTÈME DE MONTAGE ET PROCÉDÉ D'AGENCEMENT D'UNITÉS D'ALIMENTATION DE COMPOSANTS

(43) Date of publication of application: 20.10.2021
(73) Proprietor: Fuji Corporation, Chiryu-shi, Aichi 472-8686 (JP)
(72) Inventor: YASUI, Yoshihiro, Chiryu-shi, Aichi 472-8686 (JP)
(74) Representative: Grünecker Patent- und Rechtsanwälte PartG mbB
(86) International application number: PCT/JP2018/045485
(87) International publication number: WO 2020/121402

(56) References cited:
- WO-A1-2014/068712
- WO-A1-2017/033268
- WO-A1-2018/008148
- WO-A1-2018/092250
- JP-A- 2012 134 331
- JP-A- 2013 243 243
- JP-A- 2018 160 702
- JP-A- H 066 084
- JP-A- H09 312 494
- US-A- 5 170 554

## Description

### Technical Field

The present specification discloses a mounting system and a method of arranging component feeding units.

### Background Art

Conventionally, in a mounting system including a component mounter on which cassette-type component feeding units (feeders) for supplying components are detachably mounted, a system including an exchange device for automatically exchanging the component feeding units has been proposed (for example, refer to Patent Literature 1). In this system, an exchange timing of each component feeding unit is set based on a production plan of boards and a remaining amount of components in each component feeding unit, and the exchange device is controlled such that the component feeding units can be attached and detached and automatically exchanged at that exchange timing.
Patent Literature 2 relates to a component mounting system. When a board type to be manufactured is switched, a replacement robot replaces a feeder that is not used for manufacturing among feeders that have finished supplying components necessary for the component mounting operation of the last circuit board of the manufacturing.
Patent Literature 3 relates to mounting machine including a replacement of a feeder by conducting a feeder position determining process by an optimized computation process for one printed board after another.
Patent Literature 4 relates to assembling components on printed circuit boards in groups to be manufactured together. The overall set up time is minimized by arranging the components in the groups.
Patent Literature 5 relates to a setup support device capable of editing a setup list according to a change in production schedule.
Patent Literature 6 relates to a set-up change method and a set-up change device which can inhibit a device from stopping due to set-up change.

### Patent Literature

Patent Literature 1: WO2017/33268A1
Patent Literature 2: JP 2018 160702 A
Patent Literature 3: JP H09 312494 A
Patent Literature 4: US 5 170 554 A
Patent Literature 5: WO 2018/092250 A1
Patent Literature 6 WO 2014068712 A1

### Summary of the Invention

### Technical Problem

In the mounting system described above, for example, when switching production jobs such as changing a board type, if the number of component feeding units subject to an automatic exchange is increased, it takes a long time for the exchange device to perform the automatic exchange. In such a case, the start of mounting process is delayed, which leads to a decrease in the production efficiency of the entire system.

A main object of the present disclosure is to efficiently arrange the necessary component feeding units when switching the production jobs and to suppress the production efficiency from decreasing.

### Solution to Problem

The invention is defined by a mounting system according to claim 1, and by a method of arranging component feeding units (30) in a mounting system (10) according to claim 3. Further preferred embodiments are defined in the dependent claims. The present disclosure has taken following means to achieve the main object described above.

A mounting system according to the present disclosure includes: a component mounter configured to execute a mounting process of picking up components supplied from multiple component feeding units and mounting the components on a board based on a production job; and a unit exchange device configured to automatically exchange the component feeding units arranged in the component mounter. The component mounter is provided with a supply available area in which the component feeding units are arranged in such a manner that the components can be supplied, and a supply non-available area in which the component feeding units are arranged in such a manner that the components cannot be supplied. The mounting system further includes: a control device configured to control the component mounter to subsequently execute the mounting process based on each production job in a predetermined production group in a state in which a first component feeding unit for supplying the components common to multiple production jobs in the production group is arranged in the supply available area and a second component feeding unit for supplying the components required for any of the production jobs in the production group is arranged in the supply available area and the supply non-available area in a distributive manner, and control the unit exchange device to automatically exchange the second component feeding unit between the supply available area and the supply non-available area in order to arrange the second component feeding unit required for a production job after switching in the supply available area every time the production job is switched.

**In** the mounting system in the present disclosure, the mounting process based on each production job in a production group is subsequently executed in a state in which a first component feeding unit for supplying the components common to multiple production jobs in a predetermined production group is arranged in the supply available area and a second component feeding unit for supplying the components required for any of the production jobs is arranged in the supply available area and the supply non-available area in a distributive manner. In addition, the second component feeding unit is automatically exchanged between the supply available area and the supply non-available area in order to arrange the second component feeding unit required for a production job after switching in the supply available area every time the production job is switched. As a result, in a state in which the first component feeding unit which is common to multiple production jobs remains to be arranged in the supply available area, the second component feeding unit required for the production job after switching may be arranged in the supply available area every time the production job is switched. Therefore, it is possible to reduce the number of component feeding units that are automatically exchanged when the production job is switched. **In** addition, since the second component feeding unit is arranged in the supply available area and the supply non-available area in a distributive manner, it is possible to quickly arrange the second component feeding unit required for the production job after switching promptly in the supply available area. Accordingly, when switching the production jobs, the necessary component feeding units can be arranged more efficiently, and thus, it is possible to suppress the production efficiency from decreasing.

### Brief Description of Drawings

Fig. 1 is a configuration view illustrating an outline of a configuration of component mounting system 10.
Fig. 2 is a configuration view illustrating an outline of a configuration of component mounter 20.
Fig. 3 is a configuration view illustrating an outline of a configuration of feeder 30.
Fig. 4 is a configuration view illustrating an outline of a configuration of loader 50.
Fig. 5 is a configuration view relating to a control by component mounting system 10.
Fig. 6 is an explanatory diagram illustrating an example of feeder arrangement information 29.
Fig. 7 is an explanatory diagram illustrating an example of feeder arrangement information 29.
Fig. 8 is a flowchart illustrating an example of a mounting management process routine.
Fig. 9 is an explanatory diagram illustrating an example of an arrangement of feeders 30.
Fig. 10 is an explanatory diagram illustrating an example of feeder arrangement information 29B when transferring the individual feeders in buffer area 20B.
Fig. 11 is a flowchart illustrating an example of a production group setting process routine.
Fig. 12 is an explanatory diagram illustrating an example of exchange robot 150 in a modification example.

### Description of Embodiments

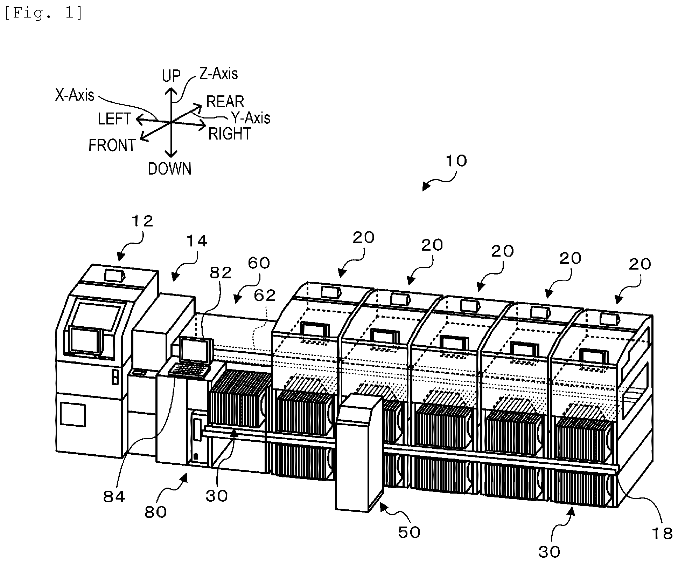

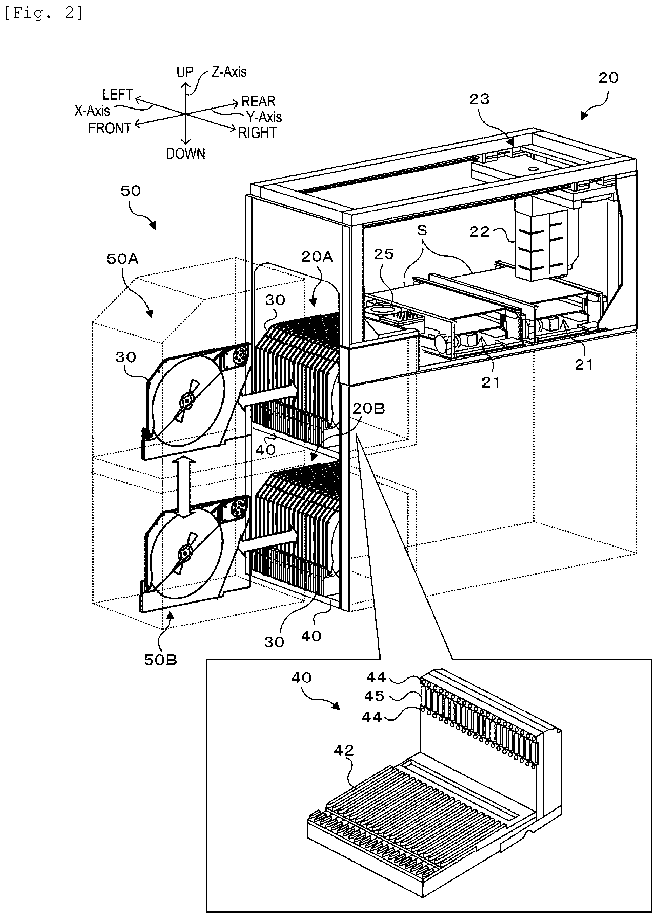

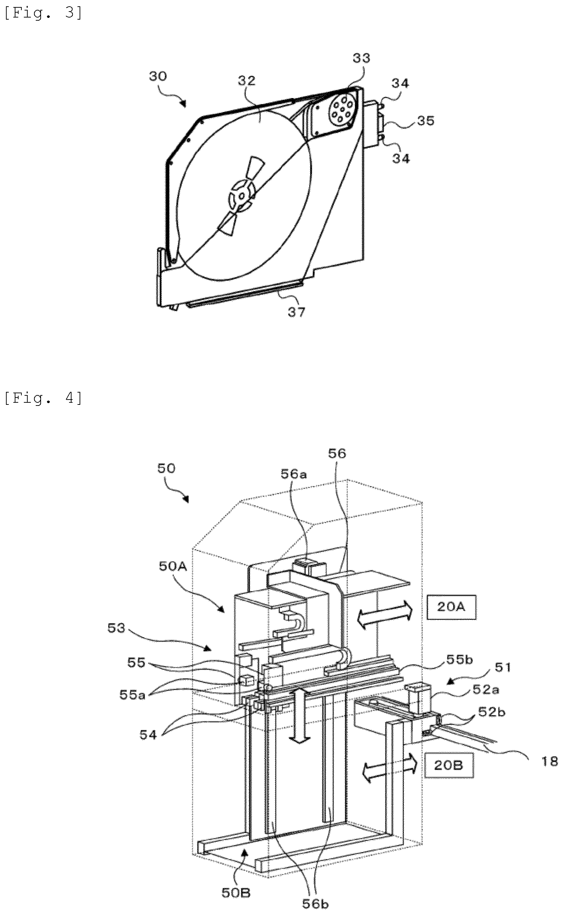

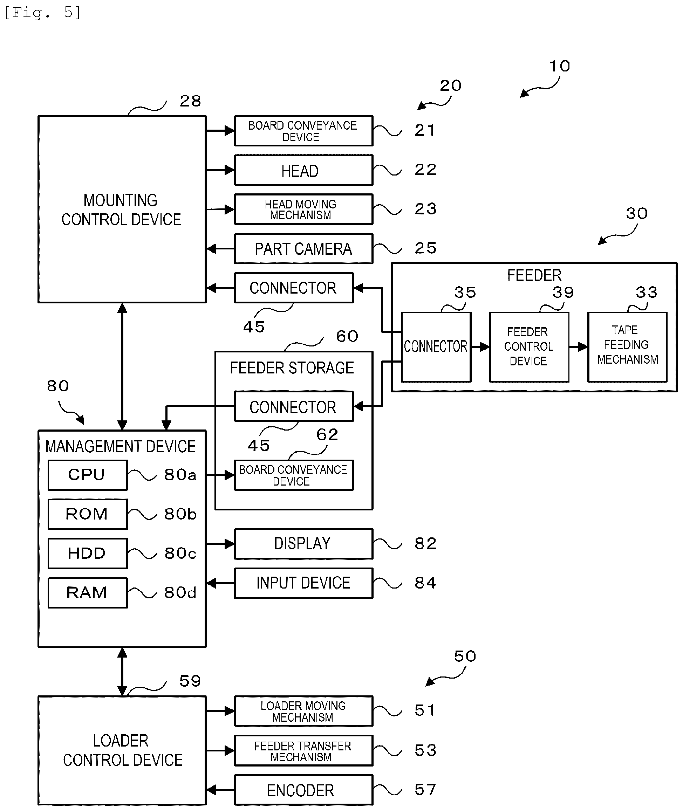

Next, an embodiment for the present disclosure will be described with reference to the drawings. Fig. 1 is a configuration view illustrating an outline of a configuration of component mounting system 10 in the present embodiment, Fig. 2 is a configuration view illustrating an outline of a configuration of component mounter 20, and Fig. 3 is a configuration view illustrating an outline of a configuration of feeder 30. In addition, Fig. 4 is a configuration view illustrating an outline of a configuration of loader 50, and Fig. 5 is a configuration view relating to a control by component mounting system 10. The left-right direction in Fig. 1 is the X-direction, the front-rear direction is the Y-direction, and the up-down direction is the Z-direction.

As illustrated in Fig. 1, component mounting system 10 includes printer 12, printing inspector 14, multiple component mounters 20, a mounting inspector (not illustrated), loader 50, feeder storage 60, and management device 80 (refer to Fig. 5). Printer 12 prints solder on board S. Printing inspector 14 inspects a state of the solder printed by printer 12. Multiple component mounters 20 are installed side by side along the conveyance direction (X-direction) of board S, and mount the components supplied from feeder 30 on board S. The mounting inspector inspects a mounting state of the components mounted by component mounter 20. Loader 50 supplies necessary feeders 30 to the multiple component mounter 20, and collects used feeders 30 from component mounter 20. Feeder storage 60 stores feeder 30 scheduled to be used by component mounters 20 and used feeders 30. Management device 80 manages the entire system. Printer 12, printing inspector 14, multiple component mounters 20, and the mounting inspector are installed side by side in the conveyance direction of board S in this order and form a production line. Feeder storage 60 is installed between component mounter 20 and printing inspector 14 at the most upstream of the production line.

As illustrated in Fig. 2, component mounter 20 includes board conveyance device 21 that conveys board S in the X-direction, head 22 including a suction nozzle for picking up the components, and head moving mechanism 23 that moves head 22 in the XY-directions, and parts camera 25 that images the components picked up by the suction nozzle from the below. In addition, component mounter 20 includes mounting control device 28 (refer to Fig. 5) which is configured with well-known CPU, ROM, RAM, and the like, to control the entire device. Mounting control device 28 inputs an image captured by parts camera 25, and outputs a drive signal to board conveyance device 21, head 22, head moving mechanism 23, and the like. In addition, component mounter 20 has two upper and lower areas to which feeder 30 can be attached in the front. The upper area is supply area 20A in which the components can be supplied to head 22, and the lower area is buffer area 20B in which the components cannot be supplied but feeder 30 can be stocked. **In** supply area 20A and buffer area 20B, feeder base 40 to which a predetermined number such as approximately several tens of feeders 30 are arranged and having an L-shaped side view is provided. Feeder base 40 may be configured such that supply area 20A has a larger number of feeders 30 arranged than that in buffer area 20B.

As illustrated in Fig. 3, feeder 30 includes tape reel 32 in which the tape is wound, tape feeding mechanism 33 that sends out the tape from tape reel 32, connector 35 having two positioning pins 34, rail member 37 provided at the lower end, and feeder control device 39 (refer to Fig. 5). **In** addition, as illustrated in Fig. 2, feeder base 40 includes multiple slots 42 that are arrayed in the X-direction at an interval in which rail member 37 of feeder 30 can be inserted, two positioning holes 44, and connector 45 provided between two positioning holes 44. When rail member 37 of feeder 30 is inserted into slot 42 of feeder base 40, two positioning pins 34 of feeder 30 are inserted into two positioning holes 44, connector 35 and connector 45 are connected to each other. Feeder control device 39 is configured with well-known CPU, ROM, RAM, and the like, and outputs a drive signal to tape feeding mechanism 33. Feeder control device 39 can communicate with a control section (mounting control device 28, management device 80, or the like.) to which feeder 30 is attached via the connections of connectors 35 and 45.

As illustrated in Fig. 1, loader 50 can move along X-axis rail 18 provided parallel to the conveyance direction (X-direction) of the board on the front of multiple component mounters 20 and the front of feeder storage 60. In Fig. 2, the illustration of X-axis rail 18 is omitted. As illustrated in Figs. 4 and 5, loader 50 includes loader moving mechanism 51, feeder transfer mechanism 53, encoder 57, and loader control device 59. Loader moving mechanism 51 moves loader 50 along X-axis rail 18, and includes X-axis motor 52a such as a servomotor that drives a driving belt and guide roller 52b that guides the movement of loader 50 along X-axis rail 18. Feeder transfer mechanism 53 transfers feeder 30 to component mounter 20 or to feeder storage 60, and includes clamp section 54 that clamps feeder 30 and Y-axis slider 55 that moves clamp sections 54 along Y-axis guide rail 55b in the front-rear direction (Y-direction) by driving Y-axis motor 55a. Feeder transfer mechanism 53 includes two Y-axis sliders 55, and can transfer multiple feeders 30 at the same time by multiple clamp sections 54. Each Y-axis slider 55 can transfer, for example, two feeders 30 at a time. In addition, feeder transfer mechanism 53 includes Z-axis motor 56a that moves slide base 56 to which clamp section 54 and Y-axis slider 55 are slidably attached, in the up-down direction (Z-direction) along Z-axis guide rail 56b. Encoder 57 detects a movement position of loader 50 in the X-direction. Loader control device 59 is configured with a well-known CPU, ROM, RAM, and the like. Loader control device 59 inputs a detection signal from encoder 57, and outputs a drive signal to loader moving mechanism 51 (X-axis motor 52a) and feeder transfer mechanism 53 (clamp section 54, Y-axis motor 55a, and Z-axis motor 56a).

When performing the automatic exchange of feeder 30, first, loader control device 59 controls X-axis motor 52a to move loader 50 to slot 42 of component mounter 20 that performs the automatic exchange. In addition, when performing the automatic exchange between supply area 20A, loader control device 59 moves slide base 56 (Y-axis slider 55) to upper transfer area 50A, when performing the automatic exchange between buffer area 20B, moves slide base 56 to lower transfer area 50B. Loader control device 59 inserts feeder 30 (rail member 37) into slot 42 by moving Y-axis slider 55 to component mounter 20 side (rearward) in a state where feeder 30 is clamped in clamp section 54, and attaches feeder 30 to feeder base 40 by releasing the clamp. In addition, by moving Y-axis slider 55 forward after moving Y-axis slider 55 to component mounter 20 side and clamping feeder 30 attached to feeder base 40 by clamp section 54, loader control device 59 detaches feeder 30 from feeder base 40 and collects feeder 30 into loader 50.

Feeder storage 60 is provided with feeder base 40 having the same configuration as feeder base 40 of component mounter 20, and can attach and detach feeder 30 by loader 50. In addition, feeder storage 60, board conveyance device 62 for conveying board S in the X-direction is provided, which can convey board S received from printing inspector 14 and delivers board S to component mounter 20.

As illustrated in Fig. 5, management device 80 is configured with well-known CPU 80a, ROM 80b, HDD 80c, RAM 80d, and the like, and includes display 82 such as an LCD and input device 84 such as a keyboard and a mouse. Management device 80 stores information on the job (production job) of board S, feeder arrangement information on the arrangement of feeders 30, and the like in HDD 80c, RAM 80d, and the like. The jobs specify which component type will be mounted on board S in what mounting order in each component mounter machine 20, and how many boards S mounted in this manner will be produced. In addition, management device 80 is communicably connected to mounting control device 28 and loader control device 59, and each control device of printer 12 and printing inspector 14 by wire or wirelessly. Management device 80 receives information relating to a mounting status of component mounter 20 and information relating to attached and detached feeder 30 from mounting control device 28, and receives information relating to a driving situation of loader 50 from loader control device 59. When the information relating to feeder 30 attached to feeder base 40 of component mounter 20 and feeder 30 removed from feeder base 40 is received from mounting control device 28, management device 80 updates the feeder arrangement information of component mounter 20. **In** addition, management device 80 outputs a drive signal to board conveyance device 62 of feeder storage 60 and causes board conveyance device 62 to convey board S. **In** addition, management device 80 is communicably connected to feeder control device 39 of feeder 30 attached to the feeder base of feeder storage 60 via connectors 35 and 45, and when the information relating to feeder 30 attached and detached to and from the feeder base is acquired, management device 80 updates the feeder arrangement information in feeder storage 60.

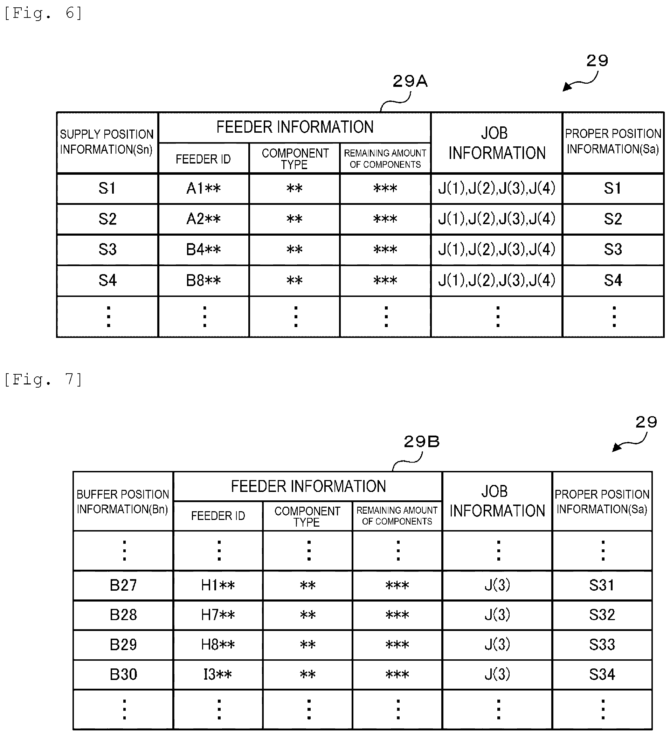

Here, Fig. 6 and Fig. 7 are explanatory diagrams illustrating examples of feeder arrangement information 29. Fig. 6 represents feeder arrangement information 29A of supply area 20A, and Fig. 7 represents feeder arrangement information 29B of buffer area 20B. Feeder arrangement information 29 includes position information indicating a slot position (number) at which each feeder 30 is arranged, feeder information such as feeder ID (identification information), and feeder information on the component type, and remaining amount of components, and job information on the jobs for which feeder 30 is used. The slot position in supply area 20A is called supply position Sn, and the slot position in buffer area 20B is called buffer position Bn. In a case of feeder 30 which is commonly used for multiple jobs, job information on multiple jobs (for example, J(1), J(2), J(3), J(4), and the like in Fig. 6) is registered. Here, for feeder 30 arranged in supply area 20A, line slot positions (predetermined positions) suitable for the mounting process in consideration of the mounting order of the components and pick up efficiency are specified, and the slot position is referred to as proper position Sa. In supply area 20A, basically feeder 30 is arranged at proper position Sa. On the other hand, in buffer area 20B, such a position is not necessary, but the Information on the proper position Sa of each feeder 30 when the feeder arrangement information 29B is arranged in supply area 20A, is also registered. It is assumed that supply position Sn and buffer position Bn are at the same slot positions corresponding to the positions in the Z-direction (up-down direction) without shifting in the X-direction. Mounting control device 28 stores feeder arrangement information 29 of component mounter 20 in a storage section such as a RAM. In addition, management device 80 stores feeder arrangement information 29 of each component mounter 20 and feeder arrangement information of feeder storage 60 in a storage section such as HDD 80c or RAM 80d.

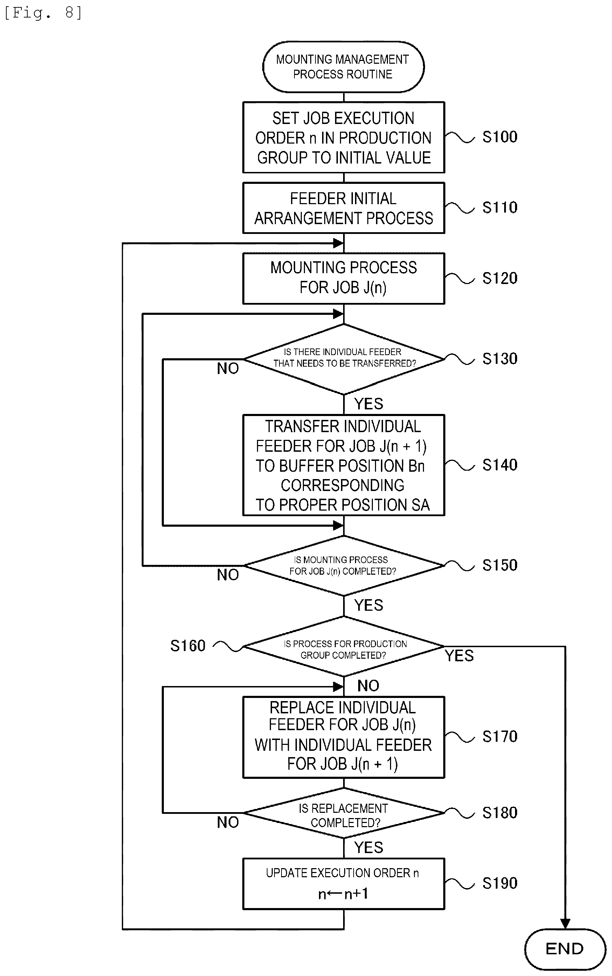

Next, the operation in component mounting system 10 configured in this way will be described. Fig. 8 is a flowchart illustrating an example of a mounting management process routine. In this routine, first, CPU 80a of management device 80 sets a job execution order n in a production group to an initial value in that production group (S100), executes a feeder initial arrangement process for arranging feeder 30 required for each job in the production group (S110) to prepare the mounting process. The production group is a group having multiple jobs, and can collectively arrange feeder 30 used in each job in supply area 20A and buffer area 20B. In the present embodiment, one production group is exemplified as having four jobs J(1) to J(4). In addition, in the present embodiment, feeder 30 for supplying a component common to all the multiple jobs of the production group is referred to as a common feeder, and feeder 30 individually required for any job of the production group is referred to as an individual feeder. For example, each feeder 30 at supply positions S1 to S4 in Fig. 6 is the common feeder for jobs J(1) to J(4), and each feeder 30 at buffer positions B27 to B30 in Fig. 7 is the individual feeder for job J(3). The individual feeder may have a feeder used in equal to or more than two jobs.

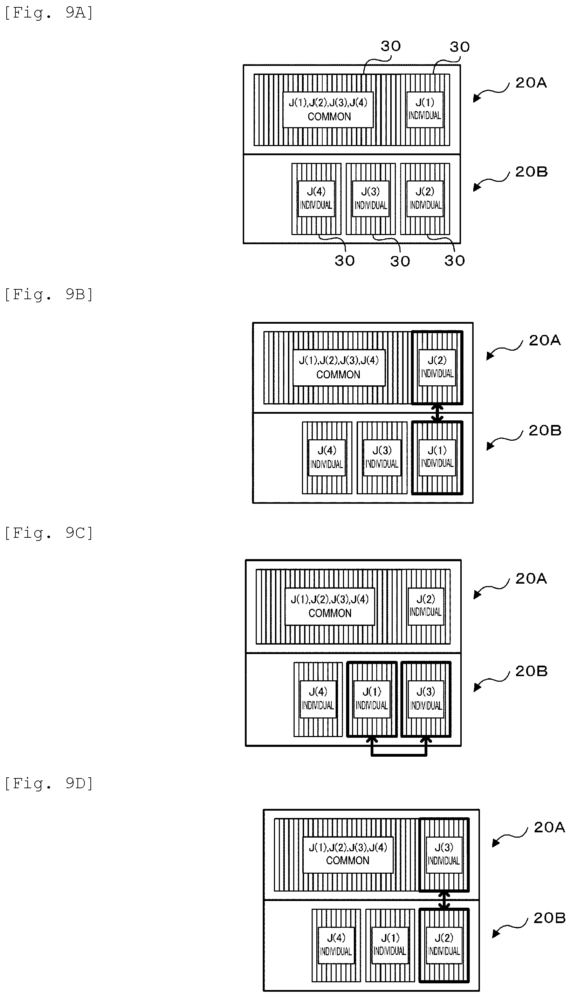

In the feeder initial arrangement process in S110, CPU 80a outputs an instruction to loader control device 59 to arrange the common feeder of each job in supply area 20A, and causes loader 50 to arrange the common feeder in supply area 20A. The common feeder is arranged in slot 42 corresponding to proper position Sa in supply area 20A. In addition, CPU 80a outputs an instruction to loader control device 59 to arrange the individual feeder for first job J(n) at proper position Sa in supply area 20A and to arrange the individual feeder for the other job in buffer area 20B, and causes loader 50 to arrange the individual feeder in supply area 20A and buffer area 20B. The individual feeder may be arranged before the arrangement of the common feeder. Fig. 9 is an explanatory diagram illustrating an example of the arrangement of feeder 30, and the common feeder and the individual feeder are indicated in different colors. Fig. 9A illustrates a state of the arrangement of feeder 30 when the feeder initial arrangement process is ended. As illustrated, the common feeder for jobs J(1) to J(4) and the individual feeder for first job J(1) are arranged in supply area 20A. In addition, the individual feeders for other jobs J(2) to J(4) are arranged in buffer area 20B. In the present embodiment, it is assumed that the common feeders are arranged side by side in a cohesive range (the range on the left side in the drawing) in supply area 20A, and the individual feeders for first job J(1) are arranged side by side in the remaining range in supply area 20A.

When the feeder initial arrangement process in S110 is executed in this way, CPU 80a outputs an instruction to mounting control device 28 and causes component mounter 20 to execute the mounting process for job J(n) (S120). In a case of the arrangement illustrated in Fig. 9A, component mounter 20 executes the mounting process of picking up the components for job J(1) from the common feeder for jobs J(1) to J(4) and the individual feeder for job J(1) using the suction nozzle of head 22 and mounting the components on board S for the number of boards S specified in advance in job J(1). During this mounting process, CPU 80a determines whether there is an individual feeder that needs to be transferred in buffer area 20B (S130). In the present embodiment, CPU 80a determines that the transfer is necessary in the following two cases. The first case is a case where, among the individual feeder for each job in buffer area 20B, the individual feeder for job J(n + 1) of which the mounting process is executed next is not present within a range corresponding to the range below the individual feeder for job J(n) which is in the mounting process. The second case is a case where the individual feeders for job J(n + 1) are not positioned at buffer position Bn corresponding to a position directly under proper position Sa when the individual feeders are arranged in supply area 20A. In the example in Fig. 9A, it is assumed that the individual feeder for next job J(2) is arranged in the range below the arrangement range of the individual feeder for job J(1) which is in the mounting process, and at buffer position Bn corresponding to each proper position Sa. In those cases, CPU 80a determines in S130 that there is no individual feeder that needs to be transferred, and skips S140. Next, CPU 80a determines whether the mounting process for job J(n) is completed (S150), and if it determines that the mounting process is not completed, returns to S130 and repeats the process.

Then, when it is determined in S150 that the mounting process for job J(n) is completed, CPU 80a determines whether the process for the production group is completed (S160). When it is determined in S150 and S160 that the mounting process for job J(n) is completed and the process for the production group is not completed, that is, when the job is switched, CPU 80a outputs an instruction to loader control device 59 to replace the individual feeder for job J(n) of which the mounting process is completed before the switching with the individual feeder for job J(n + 1) after the switching (S170), and waits for the completion of the replacement (S180). Loader control device 59 controls loader 50 based on the instruction and replaces the individual feeder for job J(n) with the individual feeder for job J(n + 1). In the example in Fig. 9, the individual feeder for job J(1) before switching and the individual feeder for job J(2) after switching are replaced (refer to Fig. 9B). As described above, the individual feeder after switching is arranged at buffer position Bn corresponding to proper position Sa, which is in buffer area 20B within a range corresponding to the range below the individual feeder before switching in supply area 20A. Therefore, loader 50 needs only to perform the automatic exchange such that the individual feeder before switching in supply area 20A is replaced with the individual feeder after switching in buffer area 20B are vertically replaced. That is, loader 50 can take out the individual feeder after switching from buffer area 20B, and quickly arrange the individual feeder at proper position Sa in supply area 20A without moving it in the X-direction (left-right direction). In addition, since only the individual feeder may be replaced without replacing the common feeder, at the time of switching the job, loader 50 can reduce the number of feeders 30 to be automatically exchanged and can shorten the time required for the automatic exchange.

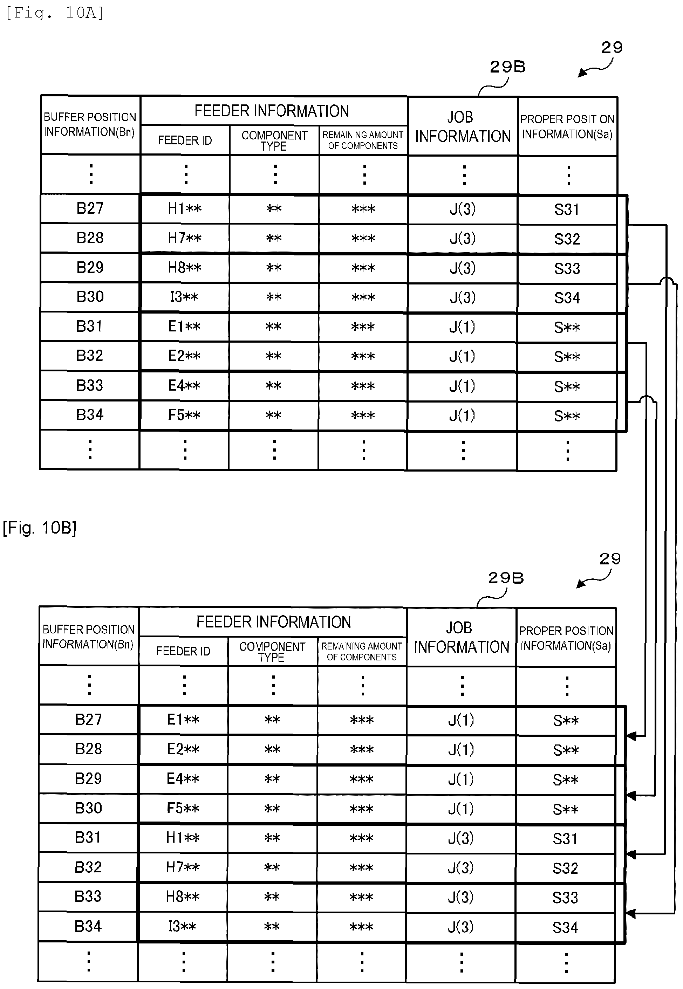

When the individual feeder is replaced in this way, CPU 80a updates execution order n by incrementing the value as much as 1 (S190), returns to S120, and executes the mounting process of job J (n). Since the individual feeder was automatically exchanged vertically in S170, below the individual feeder for job J(2) which is in the mounting process, the individual feeder for job J(1) for which the mounting process was completed is arranged. That is, since the individual feeder for job J(3) is not arranged within a range below the arrangement range of the individual feeder for job J(2) which is in the mounting process, CPU 80a determines in S130 that the individual feeder needs to be transferred. Therefore, CPU 80a outputs an instruction to loader control device 59 to transfer the Individual feeder for the next job J(n + 1) (here, job J(3)) to buffer position Bn corresponding to proper position Sa, which is the range below the arrangement range of the individual feeder for job J(n) (here, job J(2)) which is in the mounting process (S140). As a result, as illustrated in Fig. 9C, the individual feeder for job J(3) and the individual feeder for job J(1) are transferred within buffer area 20B. In addition, Fig. 10 is an explanatory diagram illustrating an example of feeder arrangement information 29B when transferring individual feeders in buffer area 20B. Fig. 10A illustrates the information before the transfer and Fig. 10B illustrates the information after the transfer. As illustrated, the individual feeder for job J(3) is transferred from buffer positions B27 to B30 to buffer positions B31 to B34 corresponding to proper positions S31 to S34. While repeating these processes, CPU 80a ends the mounting management process when it is determined in S160 that the process for the production group is completed.

Here, the correspondence relationships between the configuration elements in the present embodiment and the configuration elements in the present disclosure will be clarified. Feeder 30 in the present embodiment corresponds to the component feeding unit, component mounter 20 corresponds to the component mounter, loader 50 corresponds to the unit exchange device, supply area 20A corresponds to the supply available area, and buffer area 20B corresponds to the supply non-available area , component mounting system 10 corresponds to the component mounting system, and management device 80, loader control device 59, and mounting control device 28 correspond to the control device. In addition, by describing the operation of component mounting system 10, the method of arranging the component feeding unit in the present disclosure will also be clarified.

In component mounting system 10 described above, the mounting process based on each job is executed in sequence in a state in which the common feeder (first component feeding unit) for each job in the production group is arranged in supply area 20A and the individual feeders (second component feeding unit) for any jobs are arranged in supply area 20A and buffer area 20B in a distributive manner. In addition, every time the job is switched, in order to arrange the individual feeder required for the job after switching in supply area 20A, the individual feeders are automatically exchanged between supply area 20A and buffer area 20B by loader 50. Therefore, loader 50 only needs to automatically exchange the individual feeders, and thus, the number of feeders 30 that are automatically exchanged can be reduced. **In** addition, since the individual feeders for each job are arranged in supply area 20A and buffer area 20B in a distributive manner, loader 50 can quickly arrange the individual feeder required for the job after switching in supply area 20A.

**In** addition, in component mounting system 10, loader 50 is controlled such that, during the execution of the mounting process, the individual feeder for the job after switching is arranged within buffer area 20B, which is below the arrangement range in supply area 20A of the individual feeder for the job. Therefore, loader 50 only needs to replace the individual feeders for each job before and after switching in the up-down direction (Z-direction) to suppress the amount of movement in the X-direction, and therefore, it is possible to arrange the individual feeders more efficiently.

In addition, in component mounting system 10, loader 50 is controlled such that the individual feeder for the job after switching is arranged at buffer position Bn in buffer area 20B corresponding to proper position Sa in supply area 20A. When taking out the individual feeder for the job after switching from buffer area 20B and arranging the feeder at proper position Sa in supply area 20A, since loader 50 does not need to move the feeder in the X-direction, it is possible to arrange the individual feeder more efficiently.

It is needless to say that the present invention is not limited to the above-described embodiments, and can be implemented in various aspects as long as it belongs to the technical scope of the present invention, as defined by the appended claims.

For example, in the embodiment described above, the individual feeder for the job after switching is arranged at buffer position Bn corresponding to proper position Sa in supply area 20A, which is within the range below the arrangement range in supply area 20A for the individual feeder for the running job, however, the configuration is not limited to this. As long as buffer position Bn corresponds to proper position Sa, the individual feeder may be arranged outside the range below the arrangement range of the individual feeder for the running job. Alternatively, not limited to buffer position Bn corresponding to proper position Sa, the individual feeder for the job after switching may be arranged within the range below the arrangement range of the individual feeder for the running job.

In the embodiment, during the execution of the mounting process, the individual feeder for the job after switching is transferred, however, the configuration is not limited to this, and the transfer may not be performed. However, in order to quickly exchange the individual feeder, it is preferable to transfer the individual feeder as in the embodiment.

In the embodiment, the feeder initial arrangement process is executed by loader 50 in the mounting management process routine illustrated in Fig. 8, however, the configuration is not limited to this, and a part or all of the feeder initial arrangement process may be executed by the operator. When all the feeder initial arrangement process is executed by the operator, the mounting management process routine may be started in a state in which S110 in Fig. 8 is omitted and the common feeder is arranged in supply area 20A by the operator, and the individual feeders are arranged in supply area 20A and buffer area 20B in a distributive manner.

**In** the embodiment, the common feeder is feeder 30 that supplies the components common to all the multiple jobs in the production group, however, the configuration is not limited to this, and may be feeder 30 that supplies the components to the job common to any of a part of the multiple jobs (two or more jobs). For example, if there is a room for the number of feeders 30 to be arranged in supply area 20A, feeder 30 that supplies the components common to a part of jobs may be added to the common feeder.

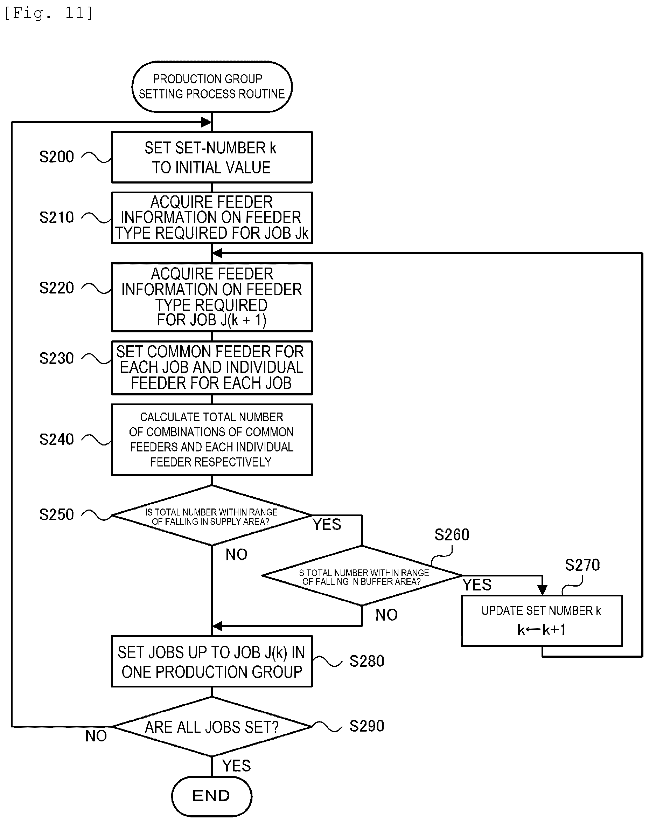

Here, the production group setting process described above may be performed by management device 80 as follows. Fig. 11 is a flowchart illustrating an example of the group setting process routine. In this routine, first, CPU 80a sets a set number k corresponding to the number of jobs included in the group to an initial value (for example, value 1) (S200), acquires feeder information on feeder 30 required for job Jk (S210) and acquires feeder information on feeder 30 required for job J(k + 1) (S220). Then, feeder 30 for the component type common to each job is set as a common feeder, and feeder 30 for other component types required for each job are set as the individual feeder (S230). Next, the total number of combinations of the common feeders and the individual feeders for each job that can be arranged in supply area 20A, and the total number of combinations of the individual feeders for each job that can be arranged in buffer area 20B are calculated respectively (S240). For example, when the set number k is a value of 1, there are the combination of the common feeders for jobs J(1) and J(2) and the individual feeder for job J(1), and the combination of the common feeders for jobs J(1) and J(2) and the individual feeder for job J (2) that are arranged in supply area 20A. In addition, when the set number k is incremented to be a value of 3, for example, there are the combination (refer to Fig. 9A) of the common feeders for jobs J(1) to J(4) and the individual feeders for job J(1), and the combination (refer to fig. 9B) of the common feeders for jobs J(1) to J(4) and the individual feeders for jobs J(2) that are arranged in supply area 20A. In addition, there are the combination (refer to Fig. 9A) of the individual feeders for jobs J(2) to J(4) and the combination (refer to Fig. 9B) of the individual feeders for jobs J(1), J(3), and J(4) that are arranged in buffer area 20B. Therefore, in S240, CPU 80a calculates total number of feeders for each of these combinations.

Then, CPU 80a determines whether the total number of combinations of feeders 30 arranged in supply area 20A is within the range of falling in supply area 20A (S250), and whether the total number of combinations of feeders 30 arranged in buffer area 20B is within the range of falling in buffer area 20B (S260), respectively. When it is determined that both are within the range in S250 and S260, the set number k is incremented by a value of 1 (S270), and the process returns to S220 and is repeated. On the other hand, when the determination in S250 or S260 is negative, CPU 80a sets the k jobs up to job Jk in one production group (S280). In this way, CPU 80a can set the production group having as many jobs as possible. When the number of jobs in each production group increases, the number of production groups is reduced, and thus, it is possible to suppress the number of times for switching the production group. Therefore, the number of executions of the initial arrangement process for feeder 30 required when switching the production group can be reduced, and thus, it is possible to improve the production efficiency of the entire jobs. CPU 80a determines whether all the jobs to be executed are set in any production group (S290), and if it is determined that all the jobs are not set, the process returns to S200 and is repeated. For example, when the jobs up to J(4) are set in one production group, a value of 5 is set as the initial value of the set number k in S200, the jobs from J5 are set in the new production group. In addition, if it is determined in S290 that all the jobs to be executed are set in any of the production groups, CPU 80a ends the production group setting process routine.

In the embodiment, buffer area 20B is arranged below supply area 20A, which exemplifies the range below the arrangement range corresponding to the arrangement range of the individual feeder in supply area 20A, however, the configuration is not limited to this, and buffer area 20B may be arranged above supply area 20A and the individual feeder for the job after switching may be arranged in the range above the arrangement range of the individual feeder in supply area 20A, or may be arranged at buffer position Bn corresponding to a position above proper position Sa in supply area 20A.

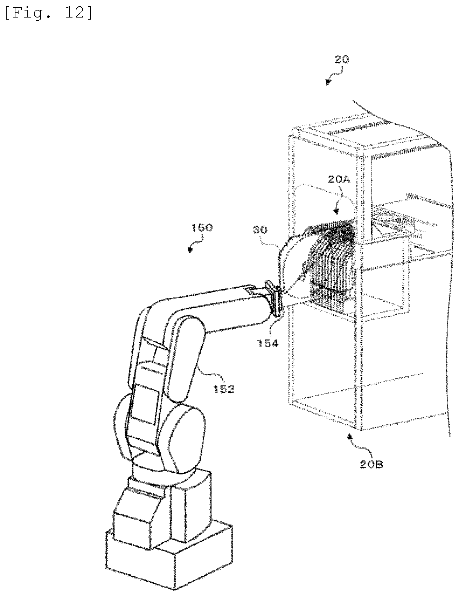

In the embodiment, loader 50 moving in the X-direction is exemplified as the unit exchange device, however, the configuration is not limited to this. In the modification example in Fig. 12, feeder 30 is automatically exchanged by exchange robot 150 including vertical articulated robot arm 152 and chuck 154 as an end effector attached to the tip of robot arm 152. In this modification example, it is assumed that buffer area 20B is not provided in component mounter 20. In addition, although not illustrated, the feeder storage for storing feeder 30 is arranged so as to face the front of component mounter 20, and exchange robot 150 is arranged between the feeder storage and component mounter 20. This feeder storage also functions as buffer area 20B of component mounter 20 in the embodiment. Exchange robot 150 performs the automatic exchange of feeder 30 between supply area 20A of component mounter 20 and the buffer area of the feeder storage by replacing the feeders while reversing the direction. Exchange robot 150 and the feeder storage may be provided for every several (for example, 2 to 3) component mounters 20. Alternatively, exchange robot 150 may be configured to be able to travel on a rail installed in the X-axis direction. Not limited to the vertical articulated type, feeder 30 may be automatically exchanged by a horizontal articulated robot, a Cartesian robot, or a parallel link robot, or may be automatically exchanged by automatically conveying feeder 30 by an AGV (automated guided vehicle).

Here, the mounting system in the present disclosure may be configured as follows. In the mounting system in the present disclosure, the component mounter may be provided with the supply available area and the supply non-available area arranged one above the other, and the control device may control the unit exchange device such that the second component feeding unit required for the production job after switching is arranged within a range in the supply non-available area corresponding to the arrangement range of the second component feeding unit in the supply available area required for the production job, during the execution of the mounting process based on the production job. In this way, when performing the automatic exchange to replace the second component feeding unit required for the production job before switching with the second component feeding unit required for the production job after switching, the unit exchange device can suppress the amount of movement of the component feeding units in the arrangement direction. Therefore, it is possible to efficiently arrange the component feeding units when switching the production job.

In the mounting system in the present disclosure, the component mounter may be provided with the supply available area and the supply non-available area arranged one above the other, and a predetermined position in arrangement suitable for the mounting process in the supply available area may be specified for each component feeding unit. The control device may control the unit exchange device such that the second component feeding unit required for the production job after switching is arranged at a position in the supply non-available area corresponding to the predetermined position in the supply available area, during the execution of the mounting process based on the production job. In this way, when taking out the second component feeding unit required for the production job after switching from the supply non-available area and arranging it in a predetermined position in the supply available area, since there is no need to move the component feeding unit in the arrangement direction, the unit exchange device can arrange the component feeding unit more efficiently.

A method of arranging component feeding units in the present disclosure is a method of arranging component feeding units in a mounting system that includes a component mounter configured to execute a mounting process of picking up components supplied from multiple component feeding units and mounting the components on a board based on a production job, and a unit exchange device configured to automatically exchange the component feeding units arranged in the component mounter. The method includes: causing the unit exchange device to automatically exchange the second component feeding units between a supply available area in which the components can be supplied and a supply non-available area in which the components cannot be supplied in order to arrange the second component feeding unit required for a production job after switching in the supply available area every time the production job is switched, in a case of causing the component mounter to subsequently execute the mounting process based on each production job in a predetermined production group in a state in which a first component feeding unit for supplying the components common to multiple production jobs in the production group is arranged in the supply available area and a second component feeding unit for supplying the components required for any of the production jobs in the production group is arranged in the supply available area and the supply non-available area in a distributive manner.

In the method of arranging the component feeding units in the present disclosure, similarly to the mounting system described above, when switching the production jobs, the necessary component feeding units can be arranged more efficiently, and thus, it is possible to suppress the production efficiency from decreasing. In the method of arranging the component feeding units, various aspects of the mounting system described above may be adopted, or steps to realize each function of the mounting system described above may be added.

### Industrial Applicability

The present invention can be used in the manufacturing industry of component mounting systems and the like.

### Reference Signs List

10 component mounting system, 12 printer, 14 printing inspector, 18 X-axis rail, 20 component mounter, 20A supply area, 20B buffer area, 21 board conveyance device, 22 head, 23 head moving mechanism, 25 parts camera, 28 mounting control device, 29, 29A, 29B feeder arrangement information, 30 feeder, 32 tape reel, 33 tape feeding mechanism, 34 positioning pin, 35 connector, 37 rail member, 39 feeder control device, 40 feeder base, 42 slot, 44 positioning hole, 45 connector, 50 loader, 50A upper transfer area, 50B lower transfer area, 51 loader moving mechanism, 52a X-axis motor, 52b guide roller, 53 feeder transfer mechanism, 54 clamp section, 55 Y-axis slider, 55a Y-axis motor , 55b Y-axis guide rail, 56 slide base, 56a Z-axis motor, 56b Z-axis guide rail, 57 encoder, 59 loader control device, 60 feeder storage, 62 board conveyance device, 80 management device, 80a CPU, 80b ROM, 80c HDD, 80d RAM, 82 display, 84 input device, 150 exchange robot, 152 robot arm, 154 chuck, S board

## Claims

1. A mounting system (10) comprising:
a component mounter (20) configured to execute a mounting process of picking up components supplied from multiple component feeding units (30) and mounting the components on a board based on a production job (J(1), J(2), J(3), J(4)); and
a unit exchange device (50) configured to automatically exchange the component feeding units (30) configured to be arranged in the component mounter (20),
wherein the component mounter (20) comprises a supply available area (20A) in which the component feeding units (30) are arranged in such a manner that the components can be supplied, and a buffer area (20B) in which the component feeding units (30) are arranged in such a manner that the components cannot be supplied, wherein the supply available area (20A) and the buffer area (20B) are arranged one above the other,
the mounting system (10) further comprises:
a control device (59) configured to control the component mounter (20) to subsequently execute the mounting process based on each production job (J(1), J(2), J(3), J(4)) in a predetermined production group, which includes multiple production jobs (J(1), J(2), J(3), J(4)) in a production job execution order, such that a first component feeding unit (30) for supplying a component common to multiple production jobs (J(1), J(2), J(3), J(4)) in the production group is arranged in the supply available area (20A), a second component feeding unit (30) for supplying a component required individually for a present production job (J(1)) in the production group is arranged in the supply available area (20A) and a third component feeding unit (30) for supplying a component required for a production job (J(2), J(3), J(4)) in the production group not being the present production job J(1) is arranged in the supply buffer area (20B), and
**characterized in that**
the mounting system (10) further comprises:
a management device (80) configured to set the production job execution order in the production group to an initial value, wherein when the management device (80) determines that the mounting process for the present production job is completed (S160) but that the process for the production group is not completed (S170),
that is, when switching from the present production job (J(1)) to a next production job (J(2)), the management device (80) is configured to instruct the control device (59) to replace the second component feeding unit (30) for the present production job (J(1)), of which the mounting process is completed before the switching, with the third component feeding unit for the next production job (J(2)) in the production job execution order after the switching,
wherein, during the execution of the mounting process based on the present production job (J(1)), the control device (59) is configured to control the unit exchange device (50) such that the third component feeding unit (30) required for the next production job (J(2)) after switching is arranged within a range in the buffer area (20B) corresponding to an arrangement range of the second component feeding unit (30) in the supply available area (20A) required for the present production job,
wherein the control device (59) is further configured to control the unit exchange device (50) to automatically exchange the second component feeding unit (30) and the third component feeding unit (30) between the supply available area (20A) and the buffer area (20B) in order to arrange the third component feeding unit (30) required for the next production job (J(2)) after switching in the supply available area (20A), every time the production job (J(1), J(2), J(3), J(4)) is switched.

2. The mounting system according to claim 1,
wherein a predetermined position in arrangement suitable for the mounting process in the supply available area (20A) is specified for each component feeding unit (30), and
wherein, during the execution of the mounting process based on the present production job (J(1)), the control device (59) is configured to control the unit exchange device (50) such that the third component feeding unit (30) required for the next production job (J(2)) after switching is arranged at a position in the buffer area (20B) corresponding to the predetermined position in the supply available area (20A).

3. A method of arranging component feeding units (30) in a mounting system (10) that includes a component mounter (20) configured to execute a mounting process of picking up components supplied from multiple component feeding units (30) and mounting the components on a board based on a production job, the mounting system (10) further comprising a control device (59), a management device (80) and a unit exchange device (50) configured to automatically exchange the component feeding units (30) arranged in the component mounter (20), wherein the component mounter (20) comprises a supply available area (20A) in which the component feeding units (30) are arranged in such a manner that the components can be supplied, and a buffer area (20B) in which the component feeding units (30) are arranged in such a manner that the components cannot be supplied, wherein the supply available area (20A) and the buffer area (20B) are arranged one above the other, the method comprising:
the control device (59) controlling the component mounter (20) to subsequently execute the mounting process based on each production job (J(1), J(2), J(3), J(4)) in a predetermined production group, which includes multiple production jobs (J(1), J(2), J(3), J(4)) in a production job execution order, such that a first component feeding unit (30) for supplying a component common to multiple production jobs (J(1), J(2), J(3), J(4)) in the production group is arranged in the supply available area (20A), a second component feeding unit Z r (30) for supplying a component required individually for a present production job (J(1)) in the production group is arranged in the supply available area (20A) and a third component feeding unit (30) for supplying a component required for a production job (J(2), J(3), J(4)) in the production group not being the present production job (J(1)) is arranged in the buffer (20B).
**characterized by**
the management device (80) setting the production job execution order in the production group to an initial value, wherein when the management device (80) determines that the mounting process for the present production job (J(1)) is completed (S160) but that the process for the production group is not completed (S170), that is, when switching from the present production job (J(1)) to a next production job (J(2)), the management device (80) instructs the control device (59) to replace the second component feeding unit (30) for the present Z r production job (J(1)), of which the mounting process is completed before the switching, with the third component feeding unit (30) for the next production job (J(2)) in the production job execution order after the switching,
during the execution of the mounting process based on the present production job (J(1)), the control device (59) controlling the unit exchange device (50) such that the third component feeding unit (30) required for the next production job (J(2)) after switching is arranged within a range in the buffer area (20B) corresponding to an arrangement range of the second component feeding unit (30) in the supply available area (20A) required for the present production job,
the control device (59) controlling the unit exchange device (50) to automatically exchange the second component feeding unit (30) and the third component feeding unit (30) between the supply available area (20A) and the buffer area (20B) in order to arrange the third component feeding unit (30) required for the next production job (J(2)) after switching in the supply available area (20A), every time the production job (J(1), J(2), J(3), J(4)) is switched.

## Patentansprüche

1. Ein Montagesystem (10), das aufweist: eine Bauteilmontagevorrichtung (20), die so konfiguriert ist, dass sie ein Montageverfahren zur Aufnahme von Bauteilen, die von mehreren Bauteilzuführeinheiten (30) zugeführt werden, und zur Montage der Bauteile auf einer Platte auf der Basis eines Produktionsauftrags (J(1), J(2), J(3), J(4)) ausführt; und
eine Einheitsaustauschvorrichtung (50), die so konfiguriert ist, dass sie die Bauteilzuführeinheiten (30) automatisch austauscht
und konfiguriert ist, um in der Bauteilmontagevorrichtung (20) angeordnet zu werden, wobei die Bauteilmontagevorrichtung (20) einen Bereitstellungsbereich (20A) aufweist, in dem die Bauteilzuführeinheiten (30) in einer solchen Weise angeordnet sind, dass die Bauteile zugeführt werden können, und einen Pufferbereich (20B), in dem die Bauteilzuführeinheiten (30) in einer solchen Weise angeordnet sind, dass die Bauteile nicht zugeführt werden können, wobei
der Bereitstellungsbereich (20A) und der Pufferbereich (20B) übereinander angeordnet sind, das Montagesystem (10) ferner aufweist:
eine Steuereinheit (59), die konfiguriert ist, um die Bauteilmontagevorrichtung (20) zu steuern, um anschließend
das Montageverfahren basierend auf jedem Produktionsauftrag (J(1), J(2), J(3), J(4)) in einer vorbestimmten
Produktionsgruppe auszuführen, die mehrere Produktionsaufträge (J(1), J(2), J(3), J(4)) in einer Reihenfolge der Ausführung von Produktionsaufträgen enthält, derart, dass
eine erste Bauteilzuführeinheit (30) zum Zuführen eines Bauteils, das mehreren Produktionsaufträgen (J(1), J(2), J(3), J(4)) in der Produktionsgruppe gemeinsam ist, in dem Bereitstellungsbereich (20A) angeordnet ist, eine zweite Bauteilzuführeinheit (30) zum Zuführen eines Bauteils, das
für einen aktuellen Produktionsauftrag (J(1 )) in der Produktionsgruppe individuell benötigt wird, im Bereitstellungsbereich (20A) angeordnet ist,
und eine zweite Bauteilzuführeinheit (30) zum Zuführen eines für einen aktuellen Produktionsauftrag (J(1)) in der Produktionsgruppe individuell benötigten Bauteils im Bereitstellungsbereich (20A) angeordnet ist und eine dritte Bauteilzuführeinheit (30) zum Zuführen eines für einen Produktionsauftrag (J(2), J(3), J(4)) in der Produktionsgruppe, der nicht der aktuelle Produktionsauftrag J(1) ist, benötigten Bauteils im zuführenden Pufferbereich (20B) angeordnet ist, und
**dadurch gekennzeichnet, dass**
das Montagesystem (10) ferner aufweist:
eine Managementvorrichtung (80), die so konfiguriert ist, dass sie die Reihenfolge der Ausführung des Produktionsauftrags in der Produktionsgruppe auf einen Anfangswert setzt,
wobei, wenn die Managementvorrichtung (80) bestimmt, dass das Montageverfahren für den vorliegenden Produktionsauftrag abgeschlossen ist (S160), aber dass
der Prozess für die Produktionsgruppe noch nicht abgeschlossen ist (S170),
d.h. beim Schalten vom aktuellen Produktionsauftrag (J(1)) zu einem nächsten Produktionsauftrag (J(2)), die Managementvorrichtung (80) so konfiguriert ist, dass sie die Steuereinheit (59) anweist, die zweite Bauteilzuführungseinheit (30) für den Produktionsauftrag (J(1)) zu ersetzen, dessen Montagevorgang vor dem Schalten abgeschlossen ist, durch die
dritte Bauteilzuführeinheit für den nächsten Produktionsauftrag (J(2)) in der Reihenfolge der Ausführung des Produktionsauftrags nach dem Schalten zu ersetzen,
wobei während der Ausführung des Montageverfahrens auf der Grundlage des aktuellen Produktionsauftrags (J(1)) die Steuereinheit (59) so konfiguriert ist, dass sie die Bauteilmontagevorrichtung (50) so steuert, dass die dritte Bauteilzuführeinheit (30), die für den nächsten Produktionsauftrag (J(2)) nach dem Schalten erforderlich ist, innerhalb eines Bereichs in dem Pufferbereich (20B) angeordnet wird, der einem Anordnungsbereich der zweiten Bauteilzuführeinheit (30) in dem für den aktuellen Produktionsauftrag erforderlichen Bereitstellungsbereich (20A) entspricht,
wobei die Steuereinheit (59) ferner konfiguriert ist, um die Einheitsaustauschvorrichtung (50) zu steuern, um die zweite Bauteilzuführeinheit (30) und die dritte Bauteilzuführeinheit (30) automatisch zwischen dem Bereitstellungsbereich (20A)
und dem Pufferbereich (20B) zu tauschen, um die dritte Bauteilzuführeinheit (30) anzuordnen, die für den nächsten Produktionsauftrag (J(2)) nach dem Schalten im Bereitstellungsbereich (20A) benötigt wird, jedes Mal, wenn der Produktionsauftrag (3(1), J(2), J(3), J(4)) geschaltet wird.

2. Das Montagesystem nach Anspruch 1,
wobei eine vorbestimmte Position in der Anordnung für den Montagevorgang im Bereitstellungsbereich (20A) für jede Bauteilzuführeinheit (30) festgelegt ist, und
wobei die Steuereinheit (59) während der Durchführung des Montageverfahrens auf der Basis des vorliegenden Produktionsauftrags (J(1)) so konfiguriert ist, dass sie die Einheitsaustauschvorrichtung (50) so steuert, dass die dritte
Bauteilzuführeinheit (30), die für den nächsten Produktionsauftrag (J(2)) benötigt wird, nach dem Schalten an einer Position im Pufferbereich (20B) angeordnet wird, die der vorbestimmten Position im Bereitstellungsbereich (20A) entspricht.

3. Ein Verfahren zum Anordnen von Bauteilzuführeinheiten (30) in einem Montagesystem (10), das eine Bauteilmontagevorrichtung (20) aufweist, die so konfiguriert ist, dass sie einen Montagevorgang zum Aufnehmen von Bauteilen, die von mehreren Komponentenzuführeinheiten (30) zugeführt werden, und zum Montieren der Bauteile auf einer Platte auf der Basis eines Produktionsauftrags ausführt, wobei das Montagesystem (10) ferner eine Steuereinheit (59), eine Managementvorrichtung (80) und eine Einheitsaustauschvorrichtung (50) aufweist
die so konfiguriert ist, dass sie automatisch die Bauteilzuführeinheiten (30) austauscht
die in der Bauteilmontagevorrichtung (20) angeordnet sind, wobei die Bauteilmontagevorrichtung (20)
einen Bereitstellungsbereich (20A) aufweist, in dem die Bauteilzuführeinheiten (30) angeordnet sind, so dass die Bauteile zugeführt werden können, und einen Pufferbereich (20B), in dem die Bauteilzuführeinheiten (30) so angeordnet sind, dass die Bauteile nicht zugeführt werden können, wobei
der Bereitstellungsbereich (20A) und der Pufferbereich (20B) übereinander angeordnet sind, wobei das Verfahren aufweist:
die Steuereinheit (59), die
die Bauteilmontagevorrichtung (20) zur anschließenden Ausführung des Montageprozesses steuert, basierend auf jedem Produktionsauftrag (J(1), J(2), J(3), J(4))
in einer vorbestimmten Produktionsgruppe, die
mehrere Produktionsaufträge (J(1), J(2), J(3), J(4)) in einer Produktionsreihenfolge der Auftragsausführung umfasst, so dass eine erste
Bauteilzuführeinheit (30) zum Zuführen eines Bauteils, das mehreren Produktionsaufträgen (J(1), J(2), J(3), J(4)) in der Produktionsgruppe entspricht, in dem Bereitstellungsbereich (20A) angeordnet ist, eine zweite Bauteilzuführeinheit (30)
zum Zuführen eines Bauteils, das individuell für einen aktuellen Produktionsauftrag (3(1)) in der Produktionsgruppe benötigt wird, im Bereitstellungsbereich (20A) angeordnet ist und
eine dritte Bauteilzuführeinheit (30) zum Zuführen eines Bauteils, das für einen Produktionsauftrag (J(2), J(3), J(4)) in der Produktionsgruppe, bei der es sich nicht um den aktuellen Produktionsauftrag (3(1)) handelt, im Pufferbereich (20B) angeordnet ist
**gekennzeichnet durch**
die Managementvorrichtung (80) die die Reihenfolge der Ausführung des Produktionsauftrags in der Produktionsgruppe
auf einen Anfangswert setzt, wobei, wenn die Managementvorrichtung (80) bestimmt, dass das Montageverfahren für den gegenwärtigen Produktionsauftrag (3(1)) abgeschlossen ist
(S160), aber dass der Prozess für die Produktionsgruppe nicht abgeschlossen ist (S170), d.h. beim Schalten von dem aktuellen Produktionsauftrag (3(1)) zu einem nächsten Produktionsauftrag (3(2)), die Managementvorrichtung (80)
die Steuereinheit (59) anweist, die zweite Bauteilzuführeinheit (30) für den aktuellen Produktionsauftrag (J(1)) auszutauschen,
dessen Montageprozess vor dem Schalten abgeschlossen ist, durch die dritte Bauteilzuführeinheit (30) für den nächsten Produktionsauftrag (J(2)) in der Reihenfolge der Ausführung des Produktionsauftrags nach dem Schalten,
die Steuereinheit (59) die Einheitsaustauschvorrichtung (50) während der Durchführung des Produktionsverfahrens auf der Basis des aktuellen Produktionsauftrages (J(1)) so steuert, dass die für den nächsten Produktionsauftrag (J(2)) nach der Umschaltung erforderliche dritte Bauteilzuführeinheit (30) innerhalb eines Bereiches im Pufferbereich (20B) angeordnet wird, der einem Anordnungsbereich der für den aktuellen Produktionsauftrag erforderlichen zweiten Bauteilzuführeinheit (30) im Bereitstellungsbereich (20A) entspricht,
die Steuereinheit (59) die Einheitsaustauschvorrichtung (50) anweist
zum automatischen Austausch der zweiten Bauteilzuführeinheit (30) und der dritten Bauteilzuführeinheit (30) zwischen dem Bereitstellungsbereich (20A) und dem Pufferbereich (20B), um die dritte Bauteilzuführeinheit (30) anzuordnen, die für den
Produktionsauftrag (J(2)) nach dem Schalten im Bereitstellungsbereich (20A) erforderlich ist, jedes Mal, wenn der Produktionsauftrag (J(1), J(2), J(3), J(4)) geschaltet wird.

## Revendications

1. Système de montage (10) comprenant :
un dispositif de montage de composants (20) configuré pour exécuter un processus de montage consistant à saisir des composants approvisionnés par de multiples unités d'alimentation en composants (30) et à monter les composants sur une carte sur la base d'une tâche de production (J(1), J(2), J(3), J(4)) ; et
un dispositif d'échange d'unités (50) configuré pour échanger automatiquement les unités d'alimentation en composants (30) configurées pour être agencées dans le dispositif de montage de composants (20),
dans lequel le dispositif de montage de composants (20) comprend une zone de disponibilité d'approvisionnement (20A) dans laquelle les unités d'alimentation en composants (30) sont agencées de manière à ce que les composants puissent être approvisionnés, et une zone tampon (20B) dans laquelle les unités d'alimentation en composants (30) sont agencées de manière à ce que les composants ne puissent pas être approvisionnés,
dans lequel la zone de disponibilité d'approvisionnement (20A) et la zone tampon (20B) sont agencées l'une au-dessus de l'autre,
le système de montage (10) comprenant en outre :
un dispositif de contrôle (59) configuré pour contrôler le dispositif de montage de composants (20) afin d'exécuter subséquemment le processus de montage sur la base de chaque tâche de production (J(1), J(2), J(3), J(4)) d'un groupe de production prédéterminé, qui inclut de multiples tâches de production (J(1), J(2), J(3), J(4)) dans un ordre d'exécution des tâches de production, de sorte qu'une première unité d'alimentation en composants (30) pour approvisionner un composant commun à de multiples tâches de production (J(1), J(2), J(3), J(4)) du groupe de production soit agencée dans la zone de disponibilité d'approvisionnement (20A), qu'une deuxième unité d'alimentation en composants (30) pour approvisionner un composant requis individuellement pour une tâche de production actuelle (J(1)) du groupe de production soit agencée dans la zone de disponibilité d'approvisionnement (20A), et qu'une troisième unité d'alimentation en composants (30) pour approvisionner un composant requis pour une tâche de production (J(2), J (3), J(4)) du groupe de production autre que la tâche de production actuelle J(1) soit agencée dans la zone tampon d'alimentation (20B), et
**caractérisé en ce que**
le système de montage (10) comprend en outre :
un dispositif de gestion (80) configuré pour définir l'ordre d'exécution des tâches de production dans le groupe de production à une valeur initiale,
dans lequel, quand le dispositif de gestion (80) détermine que le processus de montage pour la tâche de production actuelle est achevé (S160) mais que le processus pour le groupe de production n'est pas achevé (S170), c'est-à-dire lors de la commutation de la tâche de production actuelle (J(1)) à une tâche de production suivante (J(2)), le dispositif de gestion (80) est configuré pour commander au dispositif de contrôle (59) de remplacer la deuxième unité d'alimentation en composants (30) pour la tâche de production actuelle (J(1)), dont le processus de montage est achevé avant la commutation, par la troisième unité d'alimentation en composants pour la tâche de production suivante (J(2)) dans l'ordre d'exécution des tâches de production après la commutation,
dans lequel, durant l'exécution du processus de montage sur la base de la tâche de production actuelle (J(1)), le dispositif de contrôle (59) est configuré pour contrôler le dispositif d'échange d'unités (50) de sorte que la troisième unité d'alimentation en composants (30) requise pour la tâche de production suivante (J(2)) après la commutation soit agencée dans une plage de la zone tampon (20B) correspondant à une plage d'agencement de la deuxième unité d'alimentation en composants (30) dans la zone de disponibilité d'approvisionnement (20A) requise pour la tâche de production actuelle,
dans lequel le dispositif de contrôle (59) est en outre configuré pour contrôler le dispositif d'échange d'unités (50) pour échanger automatiquement la deuxième unité d'alimentation en composants (30) et la troisième unité d'alimentation en composants (30) entre la zone de disponibilité d'approvisionnement (20A) et la zone tampon (20B) afin d'agencer la troisième unité d'alimentation en composants (30) requise pour la tâche de production suivante (J(2)) après la commutation dans la zone de disponibilité d'approvisionnement (20A), chaque fois que la tâche de production (J(1), J(2), J(3), J(4)) est commutée.

2. Système de montage selon la revendication 1,
dans lequel une position prédéterminée dans un agencement approprié pour le processus de montage dans la zone de disponibilité d'approvisionnement (20A) est spécifiée pour chaque unité d'alimentation en composants (30), et
dans lequel, durant l'exécution du processus de montage sur la base de la tâche de production actuelle (J(1)), le dispositif de contrôle (59) est configuré pour contrôler le dispositif d'échange d'unités (50) de sorte que la troisième unité d'alimentation en composants (30) requise pour la tâche de production suivante (J(2)) après la commutation soit agencée à une position dans la zone tampon (20B) correspondant à la position prédéterminée dans la zone de disponibilité d'approvisionnement (20A).

3. Procédé d'agencement d'unités d'alimentation en composants (30) dans un système de montage (10) qui inclut un dispositif de montage de composants (20) configuré pour exécuter un processus de montage consistant à saisir des composants approvisionnés par de multiples unités d'alimentation en composants (30) et à monter les composants sur une carte sur la base d'une tâche de production, le système de montage (10) comprenant en outre un dispositif de contrôle (59), un dispositif de gestion (80) et un dispositif d'échange d'unités (50) configuré pour échanger automatiquement les unités d'alimentation en composants (30) agencées dans le dispositif de montage de composants (20), dans lequel le dispositif de montage de composants (20) comprend une zone de disponibilité d'approvisionnement (20A) dans laquelle les unités d'alimentation en composants (30) sont agencées de manière à ce que les composants puissent être approvisionnés, et une zone tampon (20B) dans laquelle les unités d'alimentation en composants (30) sont agencées de manière à ce que les composants ne puissent pas être approvisionnés, dans lequel la zone de disponibilité d'approvisionnement (20A) et la zone tampon (20B) sont agencées l'une au-dessus de l'autre, le procédé comprenant :
le contrôle du dispositif de montage de composants (20) par le dispositif de contrôle (59) pour exécuter subséquemment le processus de montage sur la base de chaque tâche de production (J(1), J(2), J(3), J(4)) d'un groupe de production prédéterminé, qui inclut de multiples tâches de production (J(1), J(2), J(3), J(4)) dans un ordre d'exécution des tâches de production, de sorte qu'une première unité d'alimentation en composants (30) pour approvisionner un composant commun à de multiples tâches de production (J(1), J(2), J(3), J(4)) du groupe de production soit agencée dans la zone de disponibilité d'approvisionnement (20A), qu'une deuxième unité d'alimentation en composants (30) pour approvisionner un composant requis individuellement pour une tâche de production actuelle (J(1)) du groupe de production soit agencée dans la zone de disponibilité d'approvisionnement (20A), et qu'une troisième unité d'alimentation en composants (30) pour approvisionner un composant requis pour une tâche de production (J(2), J (3), J(4)) du groupe de production autre que la tâche de production actuelle (J(1)) soit agencée dans le tampon (20B),
**caractérisé par**
la définition par le dispositif de gestion (80) de l'ordre d'exécution des tâches de production dans le groupe de production à une valeur initiale, dans lequel, quand le dispositif de gestion (80) détermine que le processus de montage pour la tâche de production actuelle (J(1)) est achevé (S160) mais que le processus pour le groupe de production n'est pas terminé (S170), c'est-à-dire lors de la commutation de la tâche de production actuelle (J(1)) à une tâche de production suivante (J(2)), le dispositif de gestion (80) commande au dispositif de contrôle (59) de remplacer la deuxième unité d'alimentation en composants (30) pour la tâche de production actuelle (J(1)), dont le processus de montage est achevé avant la commutation, par la troisième unité d'alimentation en composants (30) pour la tâche de production suivante (J(2)) dans l'ordre d'exécution des tâches de production après la commutation,
durant l'exécution du processus de montage sur la base de la tâche de production actuelle (J(1)), le contrôle du dispositif d'échange d'unités (50) par le dispositif de contrôle (59) de sorte que la troisième unité d'alimentation en composants (30) requise pour la tâche de production suivante (J(2)) après la commutation soit agencée dans une plage de la zone tampon (20B) correspondant à une plage d'agencement de la deuxième unité d'alimentation en composants (30) dans la zone de disponibilité d'approvisionnement (20A) requise pour la tâche de production actuelle,
le contrôle du dispositif d'échange d'unités (50) par le dispositif de contrôle (59) pour échanger automatiquement la deuxième unité d'alimentation en composants (30) et la troisième unité d'alimentation en composants (30) entre la zone de disponibilité d'approvisionnement (20A) et la zone tampon (20B) afin d'agencer la troisième unité d'alimentation en composants (30) requise pour la tâche de production suivante (J(2)) après la commutation dans la zone de disponibilité d'approvisionnement (20A), chaque fois que la tâche de production (J(1), J(2), J(3), J(4)) est commutée.
